# EUROPEAN PATENT APPLICATION

(11) **EP 1 548 043 A1**
(43) Date of publication of application: **29.06.2005**
(21) Application number: 03748685.9
(22) Date of filing: 02.10.2003
(51) Int. Cl.: C08G 59/62, H01L 23/29

(54) **EPOXY RESIN COMPOSITION FOR SEALING OPTICAL SEMICONDUCTOR**

(30) Priority: 03.10.2002 JP 2002290802
(71) Applicant: Nippon Kayaku Kabushiki Kaisha, Tokyo 102-8172 (JP)
(72) Inventor: KAWADA, Yoshihiro, Nippon Kayaku Kabushiki Kaisha, Kita-ku, Tokyo 115-0042 (JP); UMEYAMA, Chie, Nippon Kayaku Kabushiki Kaisha, Kita-ku, Tokyo 115-0042 (JP)
(74) Representative: Gille Hrabal Struck Neidlein Prop Roos
(86) International application number: PCT/JP2003/012677
(87) International publication number: WO 2004/031257

(57) **Abstract**

The present invention relates to an epoxy resin composition for sealing photosemiconductor, the epoxy resin composition containing
(A) a bisphenol-type epoxy resin represented by the following formula (1) 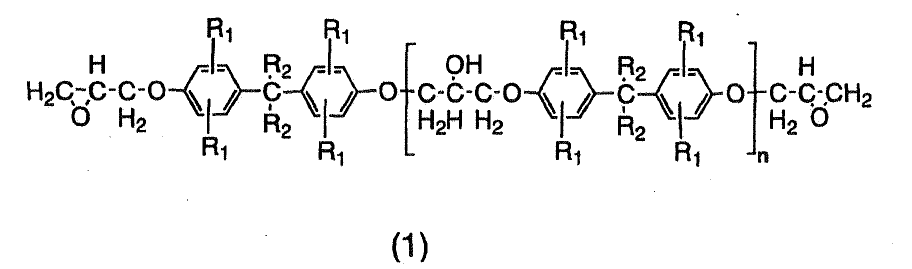 (in the formula, R₁s represent hydrogen atom, a C1 - C8 alkyl group, a halogen atom; R₂s represent hydrogen atom, a C1 - C5 alkyl group, a halogen-substituted (C1 - C5) alkyl group or phenyl group; n represents an integer), where the ratio of the total content of such bisphenol-type lower molecular epoxy resins with n = 0, 1 or 2 is 10% by weight or more of the whole resin;
(B) a terpene backbone-containing polyvalent phenol curing agent prepared by adding two molecules of phenols to one molecule of a cyclic terpene compound;
(C) a curing-promoting agent;
(D) at least one resin selected from the group consisting of epoxy resins except for the component (A) and novolak resins as a curing agent;
and an photosemiconductor device sealed with the cured material of the composition, where the composition has great workability and good productivity of sealed photosemiconductor, so that the resulting photosemiconductor sealed with the cured material of the composition has great solder reflowresistance after moisture absorption and good thermal resistance for HC.

## Description

### Technical Field

The present invention relates to an epoxy resin composition for sealing a photosemiconductor, the epoxy resin composition having great solder resistance after moisture absorption.

### Background of the Invention

Generally, airtight sealing is used for protecting opto-electronics parts such as photosemiconductor. When opto-electronics parts are sealed with a sealing agent, it is then required that the resulting sealing membrane has high light transmittance (transparency). Regarding opto-electronics parts requiring high reliability, generally, a process of airtight sealing with glass has been widely adopted. However, because the airtight sealing is costly and the productivity of opto-electronics parts is low, an economical resin sealing of general purpose parts has been gradually used for sealing common such parts. For resin sealing, generally, epoxy resin compositions are used. Then, acid anhydrides are used as curing agents. Cured materials of the epoxy resin compositions contain ester bonds formed by the reaction of acid anhydrides and epoxy group, so the ester bonds are hydrolyzed when the cured materials (for example, resin membranes for airtight sealing) are stored at high humidity. Therefore, the adhesion and transparency are disadvantageously deteriorated. Because wires in connection to photosemiconductor devices sealed with resins are sometimes cut by the thermal expansion of the sealing resins, an epoxy resin composition with a glass transition temperature (Tg) of 105°C or more, preferably 110°C or more is needed.

In case of airtight sealing having no epoxy resin composition using a phenol compound without ester bond as a curing agent, the resulting cured material (resin membrane for airtight sealing) can retain transparency after storage at high humidity. Therefore, the said curing agent is superior to curing agents using acid anhydrides. However, in recent years, a new problem of the occurrence of peeling in the adhesive face between the sealed resin and the lead frame during solder reflow after moisture absorption has now been drawing attention because of higher solder melting temperatures (solder resistance after moisture absorption). Particularly, not any cured resin (sealing material) satisfying all the required conditions has been obtained yet from epoxy resin compositions using any of the curing agents for Ag-plated lead frames. Additionally, JP-A-2001-2758 proposes an epoxy resin composition using terpene backbone-containing polyvalent phenol as a curing agent. The cured material obtained from the epoxy resin composition can overcome some of the disadvantages of the conventional art, however, it is not sufficiently satisfactory. It is an object of the invention to provide an epoxy resin composition for sealing photosemiconductor, which can produce a resin-sealed photosemiconductor with great solder reflow resistance after moisture absorption and has great processability (productivity of sealed photosemiconductor device).

### Disclosure of the Invention

The present inventors have made investigations so as to solve the problems described above. Consequently, the inventors have found that an epoxy resin composition capable of overcoming the problems described above for photosemiconductor can be obtained by using at least one resin as the component D, which is selected from the group consisting of epoxy resins except for the component (A) and novolak resins as curing agents, in combination with an epoxy resin as the component (A), a terpene backbone-containing polyvalent phenol curing agent as the component (B) and a curing-promoting agent (C). In other words, the invention relates to those described below.
1. An epoxy resin for sealing a photosemiconductor, comprising
   (A) a bisphenol-type epoxy resin represented by the following formula (1) 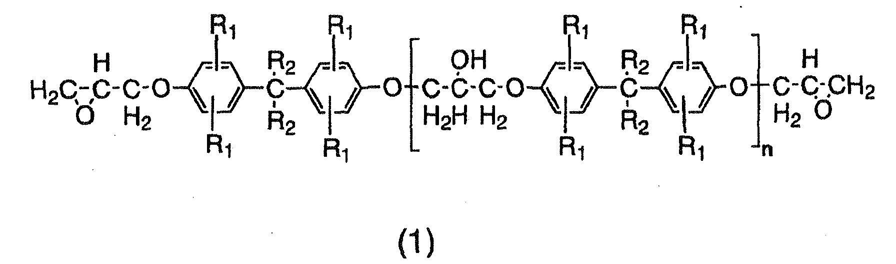 (wherein, R₁s represent hydrogen atom, a C1 - C8 alkyl group, a halogen atom, which may be the same or different; R₂s represent hydrogen atom, a C1 - C5 alkyl group, a halogen-substituted (C1 - C5) alkyl group or phenyl group, which may be the same or different; n represents an integer, where the ratio of the total content of such bisphenol-type lower molecular epoxy resins with n = 0, 1 or 2 is 10% by weight or more based on the whole resin;
   (B) a terpene backbone-containing polyvalent phenol curing agent produced by adding two molecules of phenols to one molecule of a cyclic terpene compound;
   (C) a curing-promoting agent;
   (D) at least one resin selected from the group consisting of epoxy resins except for the component (A) and novolak resins as curing agents.
2. The epoxy resin composition for sealing photosemiconductor according to the above 1 containing epoxy resins except for the component (A), where the ratio of the total content of such lower molecular epoxy resins with n = 0, 1 or 2 in the formula (1) is 10% by weight or more of the whole epoxy resin.
3. The epoxy resin composition for sealing photosemiconductor according to the above 1, where the ratio of the total content of the said lower molecular epoxy resins in the epoxy resin of the component (A) is 15 to 50% by weight based on the whole epoxy component (A).
4. The epoxy resin composition for sealing photosemiconductor according to the above 1 or 3 containing epoxy resins as the component (D) except for the epoxy resin as the component (A) at 20 to 90% by weight and the epoxy resin as the component (A) at 10 to 80% by weight based on the whole epoxy resin.
5. An epoxy resin composition for sealing photosemiconductor according to the above 1 or 4 where the epoxy resins except for the component (A) are biphenyl backbone-containing phenol novolak resins.
6. An epoxy resin composition for sealing photosemiconductor according to the above 1, where the component (A) is bisphenol type-A and/or bisphenol type-F epoxy resin.
7. An epoxy resin composition for sealing photosemiconductor according to the above 1 where the terpene backbone-containing polyvalent phenol curing agent as the component (B) is of a bifunctional type.
8. A photosemiconductor device sealed with an epoxy resin composition according to any one of the above 1 to 7.
9. A method for producing sealed photosemiconductor device, including a photosemiconductor device sealing with an epoxy resin composition according to any one of the 1 to 7.
10. An epoxy resin composition according to any one of the above 1 to 7 where a cured product of the resin composition has a glass transition temperature of 105°C or more and the ratio of the peeled area of the cured resin is 60% or less after absorption of moisture in the photosemiconductor device sealed with the said cured products.

### Best Mode for Carrying out the Invention

The epoxy resin as the component (A) for use in the present invention (also referred to as epoxy resin (A) hereinafter) contains the said low molecular epoxy resins where n is 0, 1 or 2 in the formula (1) at 10% by weight or more (the term "%" means "% by weight" hereinbelow unless otherwise stated), preferably 15% or more, more preferably 20% or more of the total weight of the epoxy resin (A). Satisfactorily, the epoxy resin (A) may wholly comprise such low molecular epoxy resins. The content thereof is preferably 80% or less, more preferably 60% or less, still more preferably 50% or less, and most preferably 40% or less. The low molecular epoxy resins may comprise any one type of such epoxy resins where n is 0, 1 or 2 or may comprise a mixture of two or more thereof where n is 0, 1 and 2. Generally, the low molecular epoxy resins comprise the three thereof in mixture. The contents of the individual epoxy resins in the total of the low molecular epoxy resins are not specifically limited. Generally, however, the content of the low molecular epoxy resin with n = 0 is 30% or less; the content of such low molecular epoxy resin with n = 1 is 25 to 40%; and such lowmolecular epoxy resin with n = 2 occupies the remaining part. The content of the low molecular epoxy resin with n = 2 is preferably 30% or more, more preferably 40% or more. Epoxy resins containing such low molecular epoxy resins can be commercially available, for example epoxy resins manufactured by Toto Chemical, Co., Ltd. and Mitsui Chemical, Inc. Hereinafter, in some cases, the epoxy resin with n = 0 is referred to as 0 nucleus; n = 1, as 1 nucleus; and n = 2, as 2 nucleus.

Because the bisphenol-type epoxy resin is generally in a mixture of a great number of epoxy resin molecules with n = 0 to about 20 in the formula (1), it is necessary to elucidate the ratio of such low molecular epoxy resins (0 nucleus, 1 nucleus and 2 nucleus) in the epoxy resin used in accordance with the invention. As the method, GPC (gel permeation chromatography) analysis is effective.

Analytical conditions are exemplified.

### Example of GPC assay conditions

Shodex KF-803 + KF-8025 + KF-802 + KF-801

Dissolution solvent: THF (tetrahydrofuran)

Flow rate: 1 ml/min

Optical detector source: according to differential refractometry (Shimadzu RID6A)

Any analytical conditions enabling the analysis of the contents of the epoxy resins may be satisfactory, with no limitation to the analytical conditions described above.

In the formula (1), the C1 - C8 alkyl group of R₁ includes for example linear or branched alkyl groups having 1 to 8 carbon atoms, such as methyl group, ethyl group, propyl group, butyl group, pentyl group, hexyl group, heptyl group and octyl group. The halogen atom includes for example chlorine, bromine and iodine.

In the formula (1), the C1 - C5 alkyl group of R₂ includes for example linear or branched alkyl groups having 1 to 5 carbon atoms, such as methyl group, ethyl group, propyl group, butyl group and pentyl group. The halogen-substituted (C1 - C5) alkyl group includes halogen-substituted alkyl groups, where the hydrogen atoms of these alkyl groups are partially or wholly substituted with halogen atoms such as chlorine, bromine and iodine.

R₁s existing in a plural number in the formula (1) may be the same or different, but preferably, all the R₁s are hydrogen atom or methyl group. R₂s existing in a plural number in the formula (1) may be the same or different, but preferably, all the R₂s are hydrogen atom, methyl group or ethyl group. Preferable combinations of R₁ and R₂ are shown below in the table.

| | |
|---|---|
| R₁ | R₂ |
| H | CH₃ |
| CH₃ | C₂H₅ |
| CH₃ | phenyl |
| H | phenyl |
| H | H |

In the invention, the epoxy resin of the formula (1) is preferably a bisphenol type-A epoxy resin (R₁ = H, R₂ = CH₃), a bisphenol type-F epoxy resin (R₁ = H, R₂ =H), a bisphenol type-E epoxy resin, a bisphenol type-B epoxy resin, a bisphenol type-AP epoxy resin or a bisphenol type-AB epoxy resin. These epoxy resins may be used singly or in mixture thereof at appropriate ratios.

In the invention, additionally, another epoxy resin as one component (D) except for the component (A) can be used in combination, within a range which does not spoil the effect of the invention. Further, an appropriate combination with the other epoxy resin can be used to thereby achieve the better effect of the invention. In accordance with the invention, thus, the combined use of another epoxy resin as the component (D) is preferable.

Another epoxy resin includes for example polyfunctional epoxy resins which is glycidyl ether of polyphenol compounds, polyfunctional epoxy resins which is glycidyl ether of various novolak resins, alicyclic epoxy resins, aliphatic epoxy resins, heterocyclic epoxy resins, glycidyl ester-series epoxy resins, glycidylamine-series epoxy resins, and epoxy resins of halogenated phenols after glycidyl modification.

Polyfunctional epoxy resins which is glycidyl ethers of polyphenol compounds include polyfunctional epoxy resins obtained by modifying, polyphenol compounds for example bisphenol A, bisphenol F, bisphenol S, 4,4'-biphenylphenol, tetramethylbisphenol A, dimethylbisphenol A, tetramethylbisphenol F, dimethylbisphenol F, tetramethylbisphenol S, dimethylbisphenol S, tetramethyl-4,4'-biphenol, dimethyl-4,4'-biphenylphenol, 1-(4-hydroxyphenyl)-2-[4-(1,1-bis-(4-hydroxyphenyl)ethyl)ph enyl]propane, 2,2'-methylene-bis(4-methyl-6-tertbutylphenol), 4,4'-butylidene-bis(3-methyl-6-tert-butylphenol), trishydroxyphenylmethane, resorcinol, hydroquinone, pyrogallol, phenols with diisopropylidene backbone, phenols with fluorene backbone such as 1,1-di-4-hydroxyphenylfluorene, and phenolic polybutadiene into glycidyl ether.

Polyfunctional epoxy resins which is glycidyl ethers of various novolak resins include glycidyl ethers of various novolak resins, for example novolak resins from various phenols as raw materials, xylylene backbone-containing phenol novolak resins, dicyclopentadiene backbone-containing phenol novolak resins, biphenyl backbone-containing phenol novolak resins, and fluorene backbone-containing phenol novolak resins. Additionally, the various phenols described above include for example phenol, cresols, ethylphenols, butylphenols, octylphenols, bisphenol A, bisphenol F, bisphenol S and naphthols.

Alicyclic epoxy resins include for example alicyclic epoxy resins with cyclic aliphatic backbones, for example an alicylic epoxy resin with cyclohexane backbone such as 3,4-epoxycyclohexylmethyl 3',4'-cyclohexyl carboxylate.

Aliphatic epoxy resins include for example glycidyl ethers of polyvalent alcohols. Any polyvalent alcohols may be used as the polyvalent alcohols. The polyvalent alcohols include for example glycols with 2 to 6 carbon atoms, poly (C1 - C4) alkylene glycols and C5 - C6 cyclic glycols, such as 1,4-butanediol, 1,6-hexanediol, polyethylene glycol, polypropylene glycol, pentaerythritol, and xylylene glycol derivatives.

Heterocyclic epoxy resins include heterocyclic epoxy resins with hetero-rings such as isocyanuric ring and hydantoin ring.

Glycidyl ester-series epoxy resins include for example epoxy resins of carboxylic acids, such as hexahydrophthalic acid diglycidyl ester, and tetrahydrophthalic acid diglycidyl ester.

Glycidylamine-series epoxy resins include epoxy resins obtained by glycidylation of amines such as aniline, toluidine, p-phenylenediamine, m-phenylenediamine, diaminodiphenylmethane derivatives, and diaminomethylbenzene derivatives. Epoxy resins obtained by glycidyl modification of halogenated phenols after include for example bromated bisphenol A, bromated bisphenol F, bromated bisphenol S, bromated phenol novolak, bromated cresol novolak, chlorinated bisphenol S and chlorinated bisphenol A.

These epoxy resins can be used with no specific limitation. From the standpoint of transparency, such epoxy resin with less tinting property is preferable. Generally, the following epoxy resins are used: polyfunctional epoxy resins which is glycidyl ethers of phenols, glycidyl ethers of various novolak resins, alicyclic epoxy resins with cyclohexane backbone, glycidyl ethers of polyvalent alcohols (for example, 1,6-hexanediol, polyethylene glycol, polypropylene glycol), triglycidyl isocyanurate and hexahydrophthalic acid diglycidyl ester. The preferable phenols for the polyfunctional epoxy resins which is glycidyl ethers of phenols as described above include bisphenol A, bisphenol F, bisphenol S, 4,4'-biphenylphenol, tetramethyl-4,4'-biphenol, 1-(4-hydroxyphenyl)-2-[4-(1,1-bis-(4-hydroxyphenyl)ethyl)ph enyl]propane, trishydroxyphenylmethane, resorcinol, 2,6-di tert-butylhydroquinone, phenols with diisopropylidene backbone, and phenols with fluorene backbone, such as 1,1-di-4-hydroxyphenylfluorene. Additionally, preferable novolak resins for the glycidyl ethers of various novolak resins include novolak resins from various phenols as raw materials, for example phenol, cresols, bisphenol A, bisphenol S, and naphthols; dicyclopentadiene backbone-containing phenol novolak resins; biphenyl backbone-containing phenol novolak resins; and fluorene backbone-containing phenol novolak resins. Alicyclic epoxy resins with cyclohexane backbone include for example 3,4-epoxycyclohexylmethyl 3', 4'-cyclohexylcarboxylate.

Among the epoxy resins, the glycidyl ethers of phenol novolak resins containing biphenyl backbone are preferable. They include for example NC-3000 (under the trade name; manufactured by Nippon Kayaku Co., LTD.) and NC-3000H (under the trade name; Nippon Kayaku Co., LTD.). The glycidyl ethers of phenol novolak resins containing biphenyl backbone are solid at room temperature (for example, 25°C) and have a softening point of preferably 100°C or less, more preferably 75°C or less, and still more preferably 60°C or less.

If necessary, such epoxy resins may be used in combination with one or two or more thereof, to improve the properties of the resulting cured resin, such as thermal resistance.

Such another epoxy resin may be mixed with the epoxy resin of the component (A) at an arbitrary ratio to be used. When a novolak resin (curing agent) is used as the component (D), for example, content of such another epoxy resin may be added at zero content. Generally, such another epoxy resin as the component (D) is at 10 to 95% based on the whole epoxy resin (the same as above hereinbelow), preferably 20 to 90%, more preferably 30 to 85%, still more preferably 40 to 85%, while the epoxy resin of the component (A) occupies the remaining part. In other words, the content of the epoxy resin of the component (A) based on the whole epoxy resin is 5 to 90%, preferably 10 to 80%, more preferably 15 to 70%, still more preferably 15 to 60%.

From the standpoint of the adhesion to the lead frame in case of the combined use of such another epoxy resin, the ratio of the total content of the low molecular epoxy resins of the formula (1) (0-, 1-, and 2 nuclei) contained in the whole epoxy resin is 3% or more, preferably 4% or more, more preferably 7% or more. In some case, said ratio may be 10% or more, preferably 15% or more. With no strict upper limit, generally, the upper limit is 70% or less, preferably 50% or less, more preferably 30% or less. In the invention, the most preferable upper limit is 20% or less. In some cases, the upper limit is 12% or less. In this case, additionally, the component (A) for use is not specifically limited. The content of the low molecular epoxy resins with n = 0, 1 or 2 in the bisphenol type epoxy resin of the formula (1) is 15% or more, preferably 18% or more to 50% or less, more preferably 40% or less based on the whole bisphenol type epoxy resin.

The curing agent for use in the invention is any compound having cyclic terpene backbone and phenolic hydroxyl group within the molecule, with no specific limitation. As described in for example JP No. 2572293 in detail, a cyclic terpene compound is reacted with phenols to add phenols to the cyclic terpene compound at a ratio of about two molecules of the phenols to one molecule of the cyclic terpene compound and to prepare a cyclic terpene backbone-containing polyvalent phenol compound, which can be used.

Herein, the cyclic terpene compound includes compounds for example limonene (the following formula (1)), dipentene as an optical isomer of limonene, type α-pinene (the following formula (2)), type β-pinene (the following formula (3)), type α-terpinene (the following formula (4)), type β-terpinene (the following formula (5)), type γ-terpinene (the following formula (6)), type 3,8-methanediene (the following formula (7)), type 2,4-methanediene (the following formula (8)), and terpinolene (the following formula (9)).

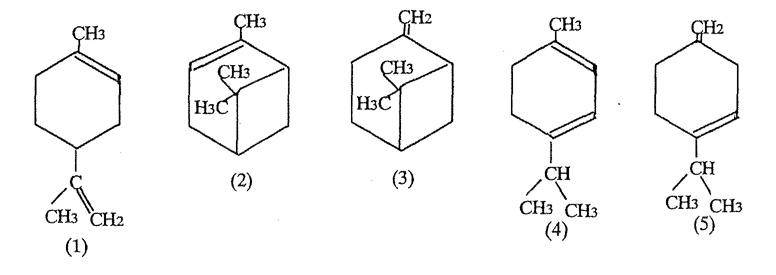

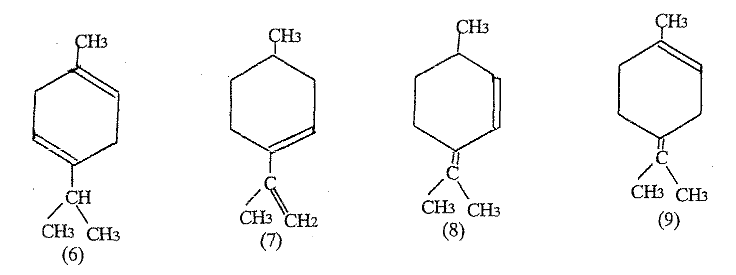

Phenols to be added to the cyclic terpene compound include for example phenol, o-cresol, m-cresol, o-ethylphenol, m-ethylphenol, o-tert-butylphenol, 2,5-xylenol, 2,6-xylenol, 2,5-diethylphenol, 2,6-diethylphenol, 2-methyl-6-tert-butylphenol, pyrocatechol, resorcinol, p-hydroquinone, 2-methylresorcinol, 4-methylresorcinol, 2,5-di-tert-butyl p-hydroquinone, o-allylphenol, 2,6-diallylphenol, 2-allyl-6-methylphenol, 2-allyl-3-methylphenol, o-chlorophenol, m-chlorophenol, o-bromophenol, m-bromophenol, 2-chloro-3-methylphenol, and 2,6-dichlorophenol.

The phenols are more preferably phenol, o-cresol, m-cresol, o-ethylphenol, m-ethylphenol, 2,5-xylenol, 2,6-xylenol, 2-methyl-6-tert-butylphenol, resorcinol, p-hydroquinone, 2-methylresorcinol, 4-methylresorcinol, 2,5-di-tert-butyl p-hydroquinone, o-allylphenol, 2,6-diallylphenol, 2-allyl-6-methylphenol and 2-allyl-3-methylphenol, particularly preferably phenol, o-cresol, m-cresol, o-ethylphenol, m-ethylphenol, 2,5-xylenol, 2,6-xylenol, resorcinol, o-allylphenol, 2,6-diallylphenol, 2-allyl-6-methylphenol and 2-allyl-3-methylphenol.

The reaction is carried out in the presence of acid catalysts such as hydrochloric acid, sulfuric acid, phosphoric acid, polyphosphoric acid and boron trifluoride. Generally, solvents such as aromatic hydrocarbons, alcohols and ethers are used.

The cyclic terpene backbone-containing polyvalent phenol compounds thus obtained are possibly a mixture of the compounds of the following formulas (I) and (II), when a compound obtained from the reaction of limonene with phenol is exemplified. It is very difficult to identify the structure.

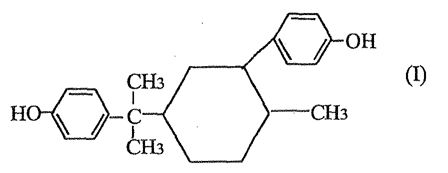

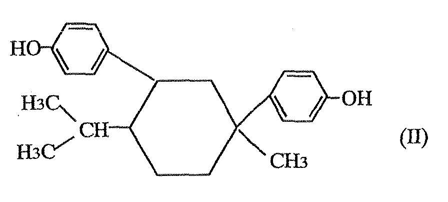

Further, a polymerized compound from the condensation reaction of the resulting cyclic terpene backbone-containing polyvalent phenol compound with one or more selected from the group consisting of aldehydes and ketones can also be used as a curing agent. The aldehydes or ketones herein usable include for example formaldehyde, paraformaldehyde, acetaldehyde, benzaldehyde, hydroxybenzaldehyde, acetone and cyclohexanone.

The cyclic terpene backbone-containing polyvalent phenol compound is preferably of a bifunctional type in accordance with the invention.

Other than the curing agent (B) for use in accordance with the invention, other curing agents may also be used in combination within a range with no deterioration of the physico-chemical properties or for the improvement of the curability in accordance with the invention. Other curing agents include for example phenol-series curing agents and acid anhydride-series curing agents.

As the phenol-series curing agent, a novolak resin is preferable. The novolak resin can be used as the component (D) together with the curing agent (B). In case of no combined use of the said another epoxy resin, preferably, the novolak resin is used in combination with the curing agent (B). The novolak resin includes for example phenol novolak resins from various phenols as raw materials, xylylene backbone-containing phenol novolak resins, dicyclopentadiene backbone-containing phenol novolak resins, biphenyl backbone-containing phenol novolak resins, and fluorene backbone-containing phenol novolak resins. The various phenols for the aforementioned use include for example bisphenol A, bisphenol F, bisphenol S, 4,4'-biphenylphenol, tetramethylbisphenol A, dimethylbisphenol A, tetramethylbisphenol F, dimethylbisphenol F, tetramethylbisphenol S, dimethylbisphenol S, tetramethyl-4,4'-biphenol, dimethyl-4,4'-biphenylphenol, 1-(4-hydroxyphenyl)-2-[4-(1,1-bis-(4-hydroxyphenyl)ethyl)ph enyl]propane,2,2'-methylene-bis(4-methyl-6-tert-butylphenol ), 4,4'-butylidene-bis(3-methyl-6-tert-butylphenol), trishydroxyphenylmethane, resorcinol, hydroquinone, pyrogallol, diisopropylidene, phenols with fluorene backbone such as 1,1-di-4-hydroxyphenylfluorene, phenolic polybutadiene, phenol, cresols, ethylphenols, butylphenols, octylphenols, bisphenol A, bisphenol F, bisphenol S and naphthols.

Among them, phenol novolak resins with phenyl-substituted C1 - C3 alkyl groups, which may have substituents C1 - C3 alkyl groups or a hydroxy substitution, are preferable from the standpoints of coloration and thermal resistance. Specifically, novolak resins such as paracresol novolak resins, orthocresol novolak resins, and bisphenol A novolak resins are preferable.

Acid anhydride-series curing agents specifically include aromatic carboxylic anhydrides such as phthalic anhydride, trimellitic anhydride, pyromellitic anhydride, benzophenone tetracarboxylic anhydride, anhydrous ethylene glycol trimellitic anhydride, and biphenyltetracarboxylic anhydride; aliphatic carboxylic anhydrides such as azelaic anhydride, sebacic anhydride, and dodecanedioic anhydride; alicyclic carboxylic anhydrides such as tetrahydrophthalic anhydride, hexahydrophthalic anhydride, nalidic anhydride, Het anhydride, and himic anhydride.

These other curing agents can be used at an amount of about 0 to 70%, preferably about 0 to 50%, more preferably 0 to 35%, still more preferably 0 to 25% based on the total amount of all the curing agents, while the remaining part is occupied by the component (B). The ratio of the content of the component (B) based on the total amount of all the curing agents is generally 30% or more, preferably 50% or more, particularly preferably 75% or more.

The ratio of these curing agents to be used to the epoxy resin is within a range of 0.5 to 1.3 equivalents, preferably within a range of 0.8 to 1.2 equivalents, still more preferably within a range of 0.9 to 1.1 equivalents to one epoxy equivalent.

The curing-promoting agent as the component (C) for use in the invention includes various imidazoles such as 2-methylimidazole, 2-phenylimidazole, 2-undecylimidazole, 2-heptadecylimidazole, 2-phenyl-4-methylimidazole, 1-benzyl-2-phenylimidazole, 1-benzyl-2-methylimidazole, 1-cyanoethyl-2-methylimidazole, 1-cyanoethyl-2-phenylimidazole, 1-cyanoethyl-2-undecylimidazole, 2,4-diamino-6(2'-methylimidazole(1'))ethyl-s-triazine, 2,4-diamino-6(2'-undecylimidazole(1'))ethyl-s-triazine, 2,4-diamino-6(2'-ethyl,4-methylimidazale(1'))ethyl-s-triazin e, 2,4-diamino-6(2'-methylimidazole(1'))ethyl-s-triazine isocyanuric acid adduct, an adduct of 2-methylimidazole isocyanuric acid at 2 :3, 2-phenylimidazole isocyanuric acid adducts, 2-phenyl-3,5-dihydroxymethylimidazole, 2-phenyl-4-hydroxymethyl-5-methylimidazole, and 1-cyanoethyl-2-phenyl-3,5-dicyanoethoxymethylimidazole; and salts of those imidazoles with polyvalent carboxylic acids such as phthalic acid, isophthalic acid, terephthalic acid, trimellitic acid, pyromellitic acid, naphthalenedicarboxylic acid, maleic acid, and oxalic acid; amides such as dicyane amide, diaza compounds such as 1,8-diaza-bicyclo(5.4.0.)undecene-7 and phenols thereof , salts thereof with the polyvalent carboxylic acids or phosphinic acids, ammonium salts such as tetrabutylammonium bromide, cetyltrimethylammonium bromide, and trioctylmethylammonium bromide, phosphines such as triphenylphosphine, and tetraphenylphosphonium tetraphenylborate, phenols such as 2,4,6-trisaminomethylphenol, amine adducts, and microcapsule type curing-promoting agents of these curing agents prepared into microcapsules. The kind and amount of such curing-promoting agent is appropriately selected, depending on the characteristic properties required for the transparent resin composition, such as transparency, curing rate and processing conditions. Generally, the curing-promoting agent is preferably phosphines, particularly preferably triphenylphosphine. These curing-promoting agents are used at about 0.2 to 10%, preferably about 1 to 5% based on the total weight of the epoxy resins.

To the epoxy resin composition in accordance with the invention may be added appropriately for example a colorant, a coupling agent, a leveling agent and a lubricant, depending on the purpose.

As the colorant, any colorant may be used with no specific limitation, and includes for example various types of organic dyes, such as phthalocyanine-series, azo-series, disazo-series, quinacridone-series, anthraquinone-series, flavanthrone-series, perinone-series, perylene-series, dioxadium-series, condensed azo-series, and azomethine-series organic dyes; and inorganic pigments such as titanium oxide, lead sulfate, chrome yellow, zinc yellow, chrome vermillion, red oxide, cobalt purple, Miloriblue, ultramarine, carbon black, chrome green, chromium oxide, and cobalt green.

The leveling agent includes oligomers having molecular weights of 4,000 to 12,000 of acrylates such as ethyl acrylate, butyl acrylate, and 2-ethylhexyl acrylate, epoxylated soybean fatty acids, epoxylated abiethyl alcohol, hydrogenated castor oil, and titanium-series coupling agents.

The lubricant includes hydrocarbon-series lubricants such asparaffinwax, microwax, andpolyethylenewax, lubricants based on higher fatty acids such as lauric acid, myristic acid, palmitic acid, stearic acid, arachidi acid, and behenic acid, higher fatty acid amides lubricants-series such as stearyl amide, palmityl amide, oleyl amide, methylenebisstearoamide, and ethylenebisstearoamide, higher fatty acid esters lubricants-series such as hardened castor oil, butyl stearate, ethylene glycol monostearate, and pentaerythritol (mono-, di-, tri- or tetra-)stearate, alcohols lubricants-series such as cetyl alcohol, stearyl alcohol, polyethylene glycol and polyglycerol, metal soaps such as salts of lauric acid, myristic acid, palmitic acid, stearic acid, arachidi acid, behenic acid, ricinoleic acid and naphthenoic acid with metals such as magnesium, calcium, cadmium, barium, zinc and lead, and naturally occurring waxes such as carnauba wax, candelilla wax, bee wax, and montan wax.

The coupling agent includes for example silane-series coupling agents such as 3-glycidoxypropyltrimethoxysilane, 3-glycidoxypropylmethyldimethoxysilane, 3-glycidoxypropylmethyldimethoxysilane, 2-(3,4-epoxycyclohexyl)ethyltrimethoxysilane, N-(2-aminoethyl) 3-aminopropylmethyldimethoxysilane, N-(2-aminoethyl) 3-aminopropylmethyltrimethoxysilane, 3-aminopropyltriethoxysilane, 3-mercaptopropyltrimethoxysilane, vinyltrimethoxysilane, N-(2-(vinylbenzylamino)ethyl) 3-aminopropyltrimethoxysilane hydrochloride salt, 3-methacryloxypropyltrimethoxysilane, 3-chloropropylmethyldimethoxysilane, and 3-chloropropyltrimethoxysilane, titanium-series coupling agents such as isopropyl (N-ethylaminoethylamino)titanate, isopropyltriisostearoyltitanate, titanium di(dioctylpyrophosphate)oxyacetate, tetraisopropyl di(dioctylphosphite)titanate, and neoalkoxytri(p-N-(β-aminoethyl)aminophenyl)titanate, and zirconium- or aluminium-series coupling agents such as Zr-acetylacetonate, Zr-methacrylate, Zr-propionate, neoalkoxyzirconate, neoalkoxytrisneodecanoylzirconate, neoalkoxytris(dodecanoyl)benzenesulfonylzirconate, neoalkoxytris(ethylenediaminoethyl)zirconate, neoalkoxytris(m-aminophenyl)zirconate, ammonium zirconium carbonate, Al-acetylacetonate, Al-methacrylate, and Al-propionate, preferably silicone-series coupling agents. By using such coupling agents, a cured material with highly reliable moisture resistance and smaller decrease of the adhesion strength after moisture absorption can be obtained.

The epoxy resin composition of the invention can be prepared by homogenously mixing together the epoxy resin of the formula (1) of the component (A), the curing agent of the component (B) (other curing agents may be used in combination if necessary), the curing-promoting agent of the component (C) and either one or both of another epoxy resin except for the epoxy resin of the component (A) and the novolak resin curing agent as the component (D), and additionally other additives if necessary, for example coupling agents, colorants and leveling agents as components to be blended, and appropriatelymolding the resulting mixture if necessary. When the blend components are solid, for example, the said composition is mixed together with blenders such as Henschel mixer and nauta mixer. Subsequently, the resulting mixture is kneaded at 80 to 120°C with kneaders, extruders, and heated rolls and is then cooled, which is pulverized into a powder form, to obtain the epoxy resin composition of the invention. When the blend components are liquid, meanwhile, the said components are homogenously mixed together with a planetary mixer and the like, to prepare the epoxy resin composition of the invention.

The resin composition has good workability and great productivity of sealed photosemiconductor and the photosemiconductor sealed with the cured material of the composition has great solder reflow resistance.

The solder reflow resistance is now specifically described.

The solder reflow resistance is generally evaluated on the basis of the ratio of the peeled area of the cured resin from the lead frame on the resin-sealed photosemiconductor device. When the resin-sealed photosemiconductor device obtained using the epoxy resin composition of the invention is immersed in a soldering bath at a temperature of 260°C for 30 seconds, the ratio of the peeled area is 10% or less, preferably 5% or less. The ratio of the peeled area when the said device is left to stand under conditions of 30°C × 70% RH for 48 hours (after moisture absorption) is 60% or less. When preferable one of the epoxy resin composition of the invention is used, the ratio of the peeled area is the same as described above even under conditions of a soldering bath temperature of 270°C and 30-second immersion, while the ratio of the peeled area after moisture absorption is 60% or less.

Further, the glass transition point (Tg) (measured with TMA (thermomechanical analyzer) at a condition of temperature-raising rate of 2°C /min)) of the cured material of the said preferable resin composition is 105°C or more, preferably 110°C or more. Thus, the cured material sufficiently passes through the heat cycle test for resin-sealed photosemiconductors.

So as to produce a sealed semiconductor device using the epoxy resin composition thus obtained in accordance with the invention, the semiconductor face of a semiconductor device is covered with the said resin composition, which is then cured, to seal the semiconductor face in air tight. In case that the epoxy resin composition of the invention is solid, more specifically, the epoxy resin composition of the invention is filled in a molding machine such as low-pressure transfer molding machine to completely cover the semiconductor face of a semiconductor device, and then primarily cured at 100 to 200°C, to prepare a molded article. Drawing out the molded article from the mold of the molding machine and again heating the molded article in an oven and the like at 100 to 200°C for complete curing, the sealed photosemiconductor device of the invention can be obtained. In case that the epoxy resin composition is liquid, meanwhile, the epoxy resin composition of the invention is poured in a mold placing an photosemiconductor device therein, for casting or dispensing so as to completely cover the photosemiconductor face with the composition. Heating then at 100 to 200°C, the epoxy resin composition is cured to prepare the sealed photosemiconductor device of the invention.

The sealed photosemiconductor device of the invention includes a receiving optics and a light emitting element, which are sealed with the epoxy resin composition of the invention. Additionally, semiconductor parts integrating the device thereon include for example DIP (dual in-line package), QFP (quad flat package), BGA (ball grid array), CSP (chip size package), SOP (small out-line package), TSOP (thin small out-line package), and TQFP (thin quad flat package).

### Example

The invention is now specifically described in the following Examples, but the invention is not limited to these examples alone. The term "part" in the Examples and Comparative Examples means "part by weight".

The following raw materials are used in accordance with the invention.
Epoxy resin 1 (EPOXY 1) 1: YD-012 (manufactured by Toto Chemical, Co., Ltd.; bisphenol type A epoxy resin at the total content of epoxy resins with n = 0, 1 and 2 being 24%: in GPC area%) Epoxy resin 2 (EPOXY 2): YD-904 (manufactured by Toto Chemical, Co., Ltd.; bisphenol type A epoxy resin at the total content of epoxy resins with n = 0, 1 and 2 being 13%: in GPC area%) Epoxy resin 3 (EPOXY 3): NC-3000 (manufactured by Nippon Kayaku Co., Ltd.; biphenyl backbone-containing novolak type epoxy resin)
Epoxy resin 4 (EPOXY 4): EOCN-104S (manufactured by Nippon Kayaku Co., Ltd.; orthocresol novolak type epoxy resin) Curing agent 1: terpene backbone-containing bifunctional phenol curing agent (158 g/eq phenol equivalent) (phenol-added limonene)
Curing agent 2: terpene backbone-containing novolak type polyfunctional phenol curing agent (174 g/eq phenol equivalent) (novolak type polyfunctional phenol-dded to limonene)
Curing agent 3: bisphenol novolak curing agent (118 g/eq phenol equivalent) (bisphenol A novolak resin)
Promoting agent: triphenylphosphine (TPP)

### Examples

### Example A

The epoxy resins (EPOXY 1, EPOXY 2, EPOXY 3, EPOXY 4), the curing agents (Curing agents 1, 2 and 3) and the curing promoting agent (TPP) shown below in Table 1 were placed at blend ratios shown in Table 1 in a blender, for mixing to homogeneity. The resulting mixtures were kneaded together under melting at a resin temperature of 60°C to 100°C with a biaxial kneader. The resulting kneaded materials were once cooled, pulverized with a pulverizer and tableted with a tableting machine, to prepare the epoxy resin compositions of the invention.

### Examples 1 to 3 and Comparative Examples 1 to 3

40 g each of the compositions (numerical figures means "part") in Table 1 shown below was filled in a mold loading a imitation lead frame (8 cm in longitudinal direction, 2 cm in crosswise direction) prepared by plating a 12-PIN SOP copper-made lead frame plated by Ag without gloss, using a low-pressure transfer, for molding at a mold temperature of 150°C and a release time period of 5 minutes. The resulting molded articles were post-cured at 150°C for one hour, to completely cure the epoxy resin compositions and to prepare pseudo-devices sealed with the cured materials of the inventive resin compositions.

These devices were left to stand alone for 48 hours under a condition (a) without moisture absorption or (b) of 30°C × 70% RH. Then, the devices were immersed in a solder bath at given temperatures for 30 seconds to observe the ratio of the resin-peeled area from the lead frame with a microscope. The results are shown in Table 1.

**Table 1**

| | Examples | | | | Comparative Examples | |
|---|---|---|---|---|---|---|
| No. | 1 | 2 | 3 | 4 | 1 | 2 |
| EPOXY 1 | 100 | 50 | | 50 | | |
| EPOXY 2 | | 50 | 100 | | 100 | |
| EPOXY 3 | | | | 50 | | |
| EPOXY 4 | | | | | | 100 |
| Curing agent 1 | 14.1 | 12.1 | 10 | 41 | | 73 |
| Curing agent 2 | 5.2 | 4.2 | | | | |
| Curing agent 3 | 3.5 | 2.8 | 5 | | 12.6 | |
| TPP | 2 | 2 | 2 | 2 | 2 | 2 |
| Total content of low-molecular materials | 24% | 18.5% | 13% | 12% | 13% | 0% |

| Results of assessment of solder resistance | | | | | | |
|---|---|---|---|---|---|---|
| No moisture absorption | | | | | | |
| 260°C | ○ | ○ | ○ | ○ | × | ○ |
| 270°C | ○ | ○ | ○ | ○ | × | ○ |

| With moisture absorption (treated at 30°C, 70% for 48 hours) | | | | | | |
|---|---|---|---|---|---|---|
| 260°C | ○ | ○ | Δ | Δ | ×× | ×× |
| 270°C | ○ | ○ | Δ | Δ | ×× | ×× |
| Note) The solder resistance as shown in Table 1 was assessed on the basis of the mean ratio of resin peeled area from lead frame in a sealed photosemiconductor device number (n) = 5. The results were ranked on the following standards. Peeled at 0 to 30%: ○ Peeled at 30 to 60%: Δ Peeled at 60 to 90%: × Peeled at 90% or more: ××. | | | | | | |

Herein, the mean ratio of the resin peeled area was calculated as follows.

The lead frame made immersion treatment in a soldering bath was photographed. Based on the photopicture, the peeled area was determined to calculate the area. The ratio of the area to the total lead frame area was expressed by %.

**Table 2**

| No. | Examples | | | Comparative Example |
|---|---|---|---|---|
| | 5 | 6 | 7 | 3 |
| EPOXY 1 | 70 | 40 | 20 | |
| EPOXY 2 | | | | |
| EPOXY 3 | 30 | 60 | 80 | 100 |
| EPOXY 4 | | | | |
| Curing agent 1 | 33.7 | 41 | 43 | 43 |
| TPP | 2 | 2 | 2 | 2 |
| Ratio of total content of low molecular materials | 16.8% | 9.6% | 4.8% | 0% |

| Results of assessment of solder resistance (ratio of peeled area) | | | | |
|---|---|---|---|---|
| With no moisture absorption | | | | |
| 260°C | 3.7% | 4.3% | 2.7% | 0% |
| 270°C | 4.5% | 4.6% | 9.3% | 5.1% |

| With moisture absorption (treated at 30°C x 70% for 48 hours) | | | | |
|---|---|---|---|---|
| 260°C | 50.5% | 53.5% | 58.4% | 92.1% |

| Thermal resistance for HC | | | | |
|---|---|---|---|---|
| TMA-Tg (°C) | 110 | 120 | 127 | 130 |

The test of the thermal resistance for HC was carried out as follows.

### Test method

Using a low-pressure transfer, the epoxy resin compositions of the invention were filled in a mold for sealing photosemiconductor device, for molding at a mold temperature of 150°C and a release time period of 5 minutes , and then post-cured. The curing was on completion under a condition of 150°C × one hour to complete the curing. The resulting cured materials were cut into a piece of a size of 10 mm × 25 mm² (the height × the bottom area). Tg was measured under a condition of a temperature raise of 2°C /min, by TMA (thermal mechanical analyzer).

### Industrial Applicability

As apparently shown in the test results in Tables 1 and 2, in accordance with the invention, the composition has great workability and good productivity of sealed photosemiconductor, and the resulting photosemiconductor sealed with the cured material of the composition has great solder reflow resistance after moisture absorption and good thermal resistance for HC.

## Claims

1. An epoxy resin for sealing photosemiconductor, comprising
(A) a bisphenol-type epoxy resin represented by the following formula (1) 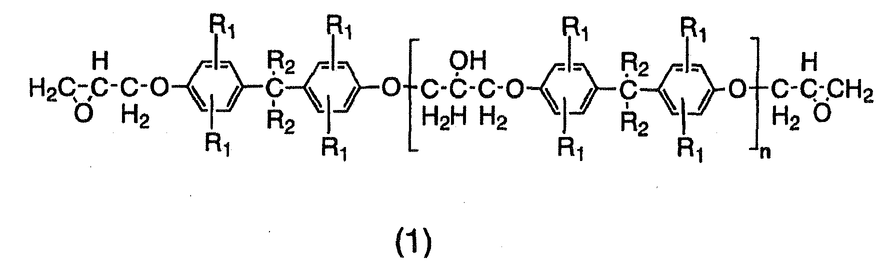 (wherein, R₁s represent hydrogen atom, a C1 - C8 alkyl group, a halogen atom, which may be the same or different; R₂s represent hydrogen atom, a C1 - C5 alkyl group, a halogen-substituted (C1 - C5) alkyl group or phenyl group, which may be the same or different; n represents an integer), where the ratio of the total content of such bisphenol-type lower molecular epoxy resins with n = 0, 1 or 2 is 10% by weight or more based on the whole resin;
(B) a terpene backbone-containing polyvalent phenol curing agent prepared by adding two molecules of phenols to one molecule of a cyclic terpene compound;
(C) a curing-promoting agent;
(D) at least one resin selected from the group consisting of epoxy resins except for the component (A) and novolak resins as curing agents.

2. The epoxy resin composition for sealing photosemiconductor according to claim 1 containing epoxy resins except for the component A, where the ratio of the total content of bisphenol-type lower molecular epoxy resins with n = 0, 1 or 2 in the formula (1) is 10% by weight or more based on the whole epoxy resin.

3. The epoxy resin composition for sealing photosemiconductor according to claim 1, where the ratio of the total content of the bisphenol-type lower molecular epoxy resins in the epoxy resin of the component (A) is 15 to 50% by weight based on the whole component (A).

4. The epoxy resin composition for sealing photosemiconductor according to claim 1 or 3 containing epoxy resins except for the epoxy resin of the component (A) as the component (D) at 20 to 90% by weight and the epoxy resin of the component (A) at 10 to 80%, by weight based on the whole epoxy resin.

5. The epoxy resin composition for sealing photosemiconductor according to claim 4, where the epoxy resins except for the component (A) are biphenyl backbone-containing phenol novolak resins.

6. The epoxy resin composition for sealing photosemiconductor according to claim 1, where the component (A) is bisphenol type-A and/or bisphenol type-F epoxy resin.

7. The epoxy resin composition for sealing photosemiconductor according to claim 1, where the terpene backbone-containing polyvalent phenol curing agent as the component (B) is of a bifunctional type.

8. A photosemiconductor device sealed with a cured material of an epoxy resin composition according to any one of claims 1 to 7.

9. A method for producing sealed photosemiconductor device **characterized by** sealing an photosemiconductor device with an epoxy resin composition according to any one of claims 1 to 7.

10. The epoxy resin composition according to any one of claims 1 to 7, where the cured product of the resin composition has a glass transition temperature of 105°C or more and the ratio of the peeled area of the cured resin after absorption of moisture in the photosemiconductor device sealed with the said cured product is 60% or less.
